# NEUE EUROPÄISCHE PATENTSCHRIFT

(11) **EP 3 150 853 B2**
(45) Veröffentlichungstag und Bekanntmachung des Hinweises auf die Entscheidung über den Einspruch: **09.03.2022**
(45) Hinweis auf die Patenterteilung: 21.03.2018
(21) Anmeldenummer: 16190711.8
(22) Anmeldetag: 27.09.2016
(51) Int. Cl.: F04B 13/00, F04B 17/04, H01L 41/12

(54) **DOSIERPUMPE, INSBESONDERE BRENNSTOFFDOSIERPUMPE FÜR EIN FAHRZEUGHEIZGERÄT**
DOSING PUMP, IN PARTICULAR FUEL DOSING PUMP FOR A VEHICLE HEATER
POMPE DE DOSAGE, EN PARTICULIER POMPE DE DOSAGE DE CARBURANT POUR UN CHAUFFAGE DE VÉHICULE

(30) Priorität: 02.10.2015 DE 102015116783
(43) Veröffentlichungstag der Anmeldung: 05.04.2017
(73) Patentinhaber: Eberspächer Climate Control Systems GmbH, 73730 Esslingen (DE)
(72) Erfinder: Humburg, Michael, 73035 Göppingen (DE)
(74) Vertreter: Ruttensperger Lachnit Trossin Gomoll

(56) Entgegenhaltungen:
- EP-A1- 0 316 164
- EP-B1- 0 997 953
- WO-A1-2012/123535
- WO-A2-99/45631
- DE-A1- 19 914 065
- DE-A1-102011 004 362
- DE-B4- 19 856 917
- DE-B4-102004 034 231
- DE-B4-102010 010 801
- US-A1- 2004 145 435
- US-A1- 2007 236 314
- US-B2- 6 886 331
- TICKLE R ET AL: "Ferromagnetic Shape Memory in the NiMnGa System", IEEE TRANSACTIONS ON MAGNETICS, IEEE SERVICE CENTER, NEW YORK, NY, US, Bd. 35, Nr. 5, 1. September 1999 (1999-09-01), Seiten 4301-4310, XP011087610, ISSN: 0018-9464, DOI: 10.1109/20.799080
- E. SUORSA et al.: "Applications of Magnetic Shape Memory Actuators", 8th International Conference on New Actuators & 2nd International Exhibition on Smart Actuators and Drive Systems, 2002, Bremen, Germany
- "chapter 7" In: Hartmut Janocha: "Unkonventionelle Aktoren: Eine Einführung", 2013 pages 175-190,

## Beschreibung

Die vorliegende Erfindung betrifft eine Dosierpumpe, insbesondere Brennstoffdosierpumpe für ein Fahrzeugheizgerät, umfassend einen in einer Pumpenkammer zum Ausstoßen und Aufnehmen von Fluid hin- und herbewegbaren Pumpenkolben und eine Antriebsanordnung für den Pumpenkolben, gemäß dem Oberbegriff des Anspruchs 1. Eine derartige Dosierpumpe ist aus der WO-A-99/45631 bekannt.

Aus der DE 10 2011 004 362 A1 ist eine Dosierpumpe zum Fördern von Brennstoff zur Brennkammer eines brennstoffbetriebenen Fahrzeugheizgeräts bekannt. Ein zum Aufnehmen von zu förderndem Brennstoff in einer Pumpenkammer und zum Ausstoßen von in der Pumpenkammer aufgenommenem Brennstoff aus der Pumpenkammer in seiner Längsrichtung hin- und herbewegbarer Pumpenkolben ist mit einem Anker fest verbunden. Der Anker bzw. der Pumpenkolben ist umgeben von einer Spule, welche bei Erregung ein Magnetfeld erzeugt. Durch Wechselwirkung mit dem Magnetfeld wird auf den Anker eine Kraft ausgeübt, welche diesen und damit den Pumpenkolben in Richtung Ausstoßen von Brennstoff aus der Pumpenkammer beaufschlagt. Bei Beendigung der Erregung der Spule und somit Beendigung der Erzeugung des Magnetfelds wird der Pumpenkolben zusammen mit dem Anker durch eine als Rückstellelement wirksame Rückstellfeder in Richtung aus der Pumpenkammer heraus bewegt. Bei seiner Hin- und Herbewegung bewegt sich der Pumpenkolben zwischen zwei Anschlägen, welchen jeweilige elastische Elemente zugeordnet sind, um in beiden Endpositionen der Hin- und Herbewegung den Anschlag des Pumpenkolbens zu dämpfen.

Aus der DE 10 2013 221 744 A1 ist eine Pumpe bekannt, durch welche flüssiger Brennstoff zu einer Brennkammer eines Fahrzeugheizgeräts gefördert werden kann. Diese Pumpe umfasst einen röhrenartigen Pumpenkörper aus magnetischem Formgedächtnismaterial. Bei Erzeugung eines Magnetfeldes wird durch Wechselwirkung mit diesem der Pumpenkörper aus magnetischem Formgedächtnismaterial verformt. Durch die Verformung wird das von dem rohrartigen Pumpenkörper umschlossene Volumen verändert. Diese bei Erregung bzw. Beenden der Erregung alternierend auftretende Volumenänderung kann dazu genutzt werden, den flüssigen Brennstoff in Richtung zu einer Brennkammer zu fördern.

Die DE 10 2010 010 801 B4 offenbart einen Aktuator mit einem Antriebselement aus magnetischem Formgedächtnismaterial. Durch eine das Antriebselement umgebende Spulenvorrichtung kann ein Magnetfeld erzeugt werden. In Reaktion auf die Erzeugung des Magnetfeldes ändert das Antriebselement aus magnetischem Formgedächtnismaterial seine Länge und verschiebt dadurch einen Stößel.

Es ist die Aufgabe der vorliegenden Erfindung, eine kostengünstig aufzubauende Dosierpumpe bereitzustellen, mit welcher eine verbesserte Dosierbarkeit des geförderten Mediums erreicht wird und die Entstehung von Anschlaggeräuschen bei der Bewegung eines Pumpenkolbens vermieden wird.

Erfindungsgemäß wird diese Aufgabe gelöst durch eine Dosierpumpe, insbesondere Brennstoffdosierpumpe für ein Fahrzeugheizgerät, umfassend einen in einer Pumpenkammer zum Ausstoßen und Aufnehmen von Fluid hin- und herbewegbaren Pumpenkolben und eine Antriebsanordnung für den Pumpenkolben.

Dabei ist weiter vorgesehen, dass die Antriebsanordnung wenigstens ein mit magnetischem Formgedächtnismaterial aufgebautes Antriebselement umfasst.

Die vorliegende Erfindung nutzt einerseits den Effekt, dass durch die Wechselwirkung mit einem Magnetfeld ein aus magnetischem Formgedächtnismaterial aufgebauter Körper, nämlich ein Antriebselement, seine Form ändert. Diese Formänderung kann bei dem erfindungsgemäßen Aufbau dazu genutzt werden, eine einen Pumpenkolben bewegende Kraft zu erzeugen. Da, anders als bei dem aus der DE 10 2013 221 744 A1 bekannten Aufbau, die Pumpwirkung durch die Hin- und Herbewegung eines Pumpenkolbens in einer Pumpenkammer erreicht wird und das Antriebselement aus magnetischem Formgedächtnismaterial lediglich zur Erzeugung einer Antriebskraft für den Pumpenkolben genutzt wird, muss auf eine komplexe Formgebung, beispielsweise Ausgestaltung als Hohlkörper, bei dem wenigstens einen Antriebselement nicht geachtet werden. Dieses kann mit vergleichsweise einfacher Gestalt bereitgestellt werden, was einerseits dessen Herstellungsvorgang vereinfacht, andererseits deutlich verminderte Herstellungskosten mit sich bringt. Da durch die Wechselwirkung mit einem Magnetfeld die Formänderung des aus magnetischem Formgedächtnismaterial aufgebauten Antriebselements sehr präzise einstellbar ist, nämlich durch Vorgabe der Magnetfeldstärke, kann entsprechend präzise auch das Ausmaß des durch das wenigstens eine Antriebselement bewegten Pumpenkolbens eingestellt werden. Somit besteht nicht nur die Möglichkeit, durch die Frequenz der Hin- und Herbewegung das Volumen des geförderten Mediums zu beeinflussen, sondern auch durch das Ausmaß, also die Amplitude der Hin- und Herbewegung. Insbesondere kann damit das Auftreten von Anschlaggeräuschen an den jeweiligen Bewegungstotpunkten vermieden werden, da einerseits durch entsprechende Variation des auf das wenigstens eine Antriebselement einwirkenden Magnetfeldes die Bewegung des Pumpenkolbens bei Annäherung an einen jeweiligen Bewegungstotpunkt verlangsamt werden kann. Andererseits kann ein unmittelbarer Anschlagkontakt des Pumpenkolbens mit dessen Bewegung begrenzenden Bauteilen bei einer jeweiligen Bewegungsumkehr praktisch vollständig vermieden werden.

Das magnetische Formgedächtnismaterial kann eine magnetische Formgedächtnislegierung umfassen. Als hinsichtlich der erreichbaren Form- bzw. Volumenänderung besonders vorteilhaft hat sich hier der Einsatz einer NiMnGa-Legierung erwiesen.

Um eine Formänderung des wenigstens einen Antriebselements und somit eine Bewegung des Pumpenkolbens erzielen zu können, wird vorgeschlagen, dass die Antriebsanordnung eine Magnetfelderzeugungseinheit, vorzugsweise mit einer elektrisch erregbaren Spulenanordnung, zur Erzeugung eines auf das wenigstens eine Antriebselement einwirkenden Magnetfeldes umfasst.

Das wenigstens eine Antriebselement beaufschlagt bei erzeugtem Magnetfeld den Pumpenkolben in einer ersten Beaufschlagungsrichtung, wobei vorzugsweise bei Beaufschlagung in der ersten Beaufschlagungsrichtung das wenigstens eine Antriebselement den Pumpenkolben in Richtung Ausstoßen von Fluid aus der Pumpenkammer beaufschlagt.

Durch die Wechselwirkung eines Antriebselements mit einem Magnetfeld kann eine Formänderung und damit eine Antriebskraft in einer Richtung erzeugt werden. Um den Pumpenkolben wieder zurückzubewegen, umfasst die Antriebsanordnung ein Rückstellelement zur Beaufschlagung des Pumpenkolbens in einer der ersten Beaufschlagungsrichtung im Wesentlichen entgegengesetzten zweiten Beaufschlagungsrichtung, wobei vorzugsweise bei Beaufschlagung in der zweiten Beaufschlagungsrichtung das Rückstellelement den Pumpenkolben in Richtung Aufnehmen von Fluid in der Pumpenkammer beaufschlagt.

Da durch die Wechselwirkung mit einem Magnetfeld das wenigstens eine Antriebselement aus magnetischem Formgedächtnismaterial nur in einer Richtung verformt werden kann, ist erfindungsgemäß das Rückstellelement dem wenigstens einen Antriebselement zum Zurückstellen des wenigstens einen Antriebselements in einen bei nicht erzeugtem Magnetfeld, also einem magnetfeldfreien Zustand, einzunehmenden Grundzustand zugeordnet ist. Somit wird durch ein- und dasselbe Bauteil bzw. ein- und dieselbe Baugruppe eine Rückstellung sowohl des Pumpenkolbens, als auch des Antriebselements bewirkt. Beispielsweise kann diese Rückstellwirkung dadurch erreicht werden, dass das Rückstellelement eine Rückstellfeder umfasst.

Um das zu fördernde Medium bzw. Fluid, also beispielsweise Brennstoff, in Richtung zur Pumpenkammer leiten zu können, ist das wenigstens eine Antriebselement in einem einen Fluideinlasskanal bereitstellenden Antriebselementengehäuse angeordnet ist.

Der Pumpenkolben ist in einem Pumpenkolbengehäuse in Richtung einer Pumpenlängsachse hin- und herbewegbar. Um dabei das Einleiten von über den Fluideinlasskanal zugeführtem Fluid in die Pumpenkammer zu erleichtern, stellen das Antriebselementengehäuse und das Pumpenkolbengehäuse eine Durchgangsöffnung für ein das wenigstens eine Antriebselement mit dem Pumpenkolben zur Antriebskraftübertragung koppelndes Übertragungsorgan und für den Durchtritt von Fluid bereit.

Um in einfacher Weise einerseits ein Gehäuse für den Pumpenkolben, andererseits ein die Pumpenkammer bereitstellendes Gehäuse vorsehen zu können, wird vorgeschlagen, dass an dem Pumpenkolbengehäuse ein die Pumpenkammer bereitstellendes Pumpenkammergehäuse vorgesehen ist. Das Pumpenkammergehäuse kann dabei auch genutzt werden, um ein den Pumpenkolben beaufschlagendes Rückstellelement abzustützen.

Zum Einleiten von zu förderndem Fluid in die Pumpenkammer kann gemäß einem besonders vorteilhaften Aspekt in dem Pumpenkolben ein diesen durchsetzender Fluiddurchtrittskanal vorgesehen sein.

Eine definierte Strömungsrichtung für das durch die Hin- und Herbewegung des Pumpenkolbens zu fördernde Fluid kann dadurch erreicht werden, dass in dem Pumpenkolben ein Einlass-Rückschlagventil vorgesehen ist, oder/und dass in einem Pumpenkammergehäuse ein Auslass-Rückschlagventil vorgesehen ist.

Die vorliegende Erfindung wird nachfolgend mit Bezug auf die beiliegenden Figuren detailliert beschrieben. Es zeigt:
- Fig. 1: eine Längsschnittansicht einer Dosierpumpe mit einem in einer ersten Endstellung positioniertem Pumpenkolben;
- Fig. 2: eine Querschnittansicht der in Fig. 1 dargestellten Dosierpumpe, geschnitten längs einer Linie II-II in Fig. 1;
- Fig. 3: eine der Fig. 1 entsprechende Darstellung bei in einer zweiten Endstellung positioniertem Pumpenkolben;
- Fig. 4: eine Querschnittdarstellung mit der Dosierpumpe der Fig. 3, geschnitten längs einer Linie IV-IV in Fig. 3;
- Fig. 5: eine Querschnittdarstellung des Pumpenkolbens der Dosierpumpe der Fig. 3, geschnitten längs einer Linie V-V in Fig. 3.

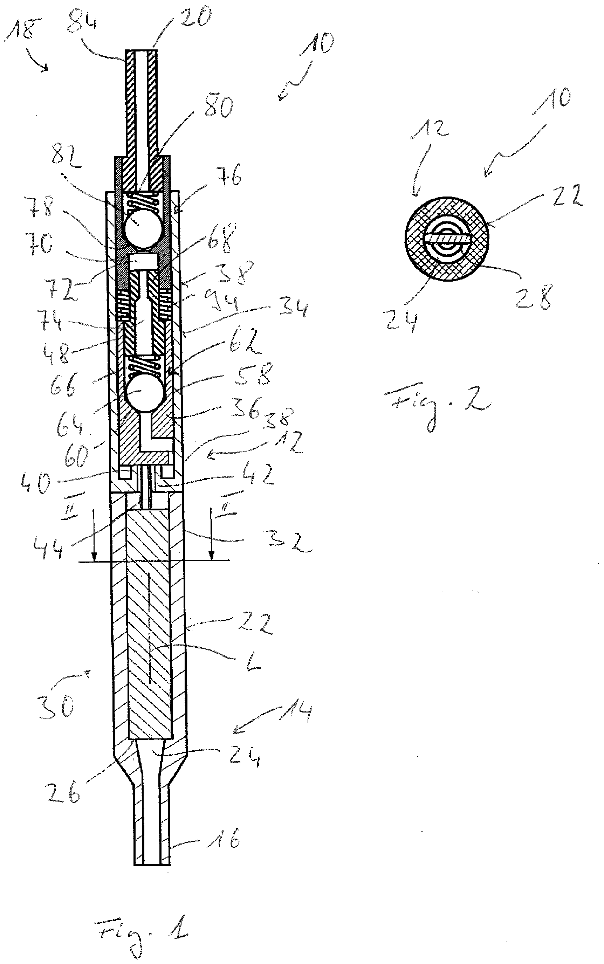

Die Fig. 1 und 2 zeigen eine allgemein mit 10 bezeichnete Dosierpumpe, welche beispielsweise dazu eingesetzt werden kann, flüssigen Brennstoff aus einem Brennstofftank in Richtung zu einer Brennkammer eines brennstoffbetriebenen Kraftfahrzeugheizgerätes zu fördern. Die Dosierpumpe 10 umfasst ein allgemein mit 12 bezeichnetes und aus mehreren Teilen zusammengesetztes Pumpengehäuse. An einem Einlassendbereich 14 des Pumpengehäuses 12 ist ein Einlassstutzen 16 vorgesehen, an welchen beispielsweise eine zu einem Brennstofftank führende Schlauchleitung angeschlossen werden kann. An einem Auslassendbereich 18 ist ein Auslassstutzen 20 vorgesehen, an welchen eine beispielsweise zu einer Brennkammer führende Schlauchleitung angeschlossen werden kann.

Das Pumpengehäuse 12 umfasst ein in Richtung einer Pumpenlängsachse L langgestrecktes Antriebselementengehäuse 22, welches den Einlassendbereich 14 und auch den Einlassstutzen 16 bereitstellt. Im Antriebselementengehäuse 22 ist ein dieses vollständig in Richtung der Pumpenlängsachse L durchsetzender Fluideinlasskanal 24 vorgesehen. Dieser Fluideinlasskanal weist im Bereich des Einlassendbereichs 14 eine stufenartige Erweiterung 26 auf, an welcher ein in Richtung der Pumpenlängsachse L langgestrecktes Antriebselement 28 aus magnetischem Formgedächtnismaterial, z. B. einer NiMnGa-Legierung, abgestützt ist. Das Antriebselement 28 bildet einen wesentlichen Bestandteil einer allgemein mit 30 bezeichneten Antriebsanordnung. Wie in Fig. 2 zu erkennen, ist das Antriebselement 28 im Wesentlichen plattenartig aufgebaut, so dass beidseits desselben ein Durchströmvolumen des Fluideinlasskanals 24 bereitgestellt ist und das zu fördernde Fluid, also beispielsweise Brennstoff, durch das Antriebselementengehäuse 22 unter Umströmung des Antriebselements 28 hindurchströmen kann.

An seinem vom Einlassendbereich 14 entfernten Endbereich 32 ist das Antriebselementengehäuse 22 mit einem gleichermaßen in Richtung der Pumpenlängsachse L langgestreckten Pumpenkolbengehäuse 34 fest und fluiddicht verbunden. In dem Pumpenkolbengehäuse 34 ist ein allgemein mit 36 bezeichneter Pumpenkolben so aufgenommen, dass er in Richtung der Pumpenlängsachse L bewegbar ist. An dem dem Endbereich 32 des Antriebselementengehäuses 22 nahe liegenden bzw. damit verbundenen Endbereich 38 des Pumpenkolbengehäuses 34 ist ein Anlageansatz 40 für den Pumpenkolben 36 vorgesehen. Im Anlageansatz 40 bzw. im Endbereich 38 des Pumpenkolbengehäuses 34 ist eine Durchgangsöffnung 42 vorgesehen, welche zusammen mit dem axial offenen Endbereich 32 des Antriebselementengehäuses 22 einerseits das Einströmen von Fluid aus dem Fluideinlasskanal 24 in das Pumpenkolbengehäuse 34 ermöglicht, andererseits den Hindurchtritt eines das Antriebselement 28 mit dem Pumpenkolben 36 zur Antriebskraftübertragung koppelnden Übertragungsorgans 44 ermöglicht.

Der Pumpenkolben 36 ist mit zwei ineinander eingesetzten und miteinander fest verbundenen Kolbenteilen 46, 48 aufgebaut. Das Kolbenteil 46 weist in seinem dem Anlageansatz 40 zugewandt liegenden Bereich einen plattenartigen Endabschnitt 50 auf, der bei an dem Anlageansatz 40 aufliegendem Pumpenkolben 36 die Durchgangsöffnung 42 gegen den Durchtritt von Fluid abschließt. In einem mit dem plattenartigen Endbereich 50, beispielsweise über drei Stege 52, 54, 56 verbunden zentralen Körperbereich 58 des Kolbenteils 46 ist ein beispielsweise konischer Ventilsitz 60 für ein allgemein mit 62 bezeichnetes Einlass-Rückschlagventil vorgesehen. Dieses umfasst ein beispielsweise als Kugel ausgebildetes Ventilelement 64, das durch eine Ventilfeder 66 auf den Ventilsitz 60 zu vorgespannt ist. Dabei stützt sich die Ventilfeder 66 an dem in das Kolbenteil 46 eingesetzten und damit fest verbundenen Kolbenteil 48 ab.

Mit seinem vom Kolbenteil 46 abgewandt liegenden Endbereich 68 greift das Kolbenteil 48 des Pumpenkolbens 36 in eine in einem Pumpenkammergehäuse 70 ausgebildete Pumpenkammer 72 ein. Bei Bewegung des Pumpenkolbens 36 in Fig. 1 nach oben, also in Richtung auf den Auslassendbereich 18 des Pumpengehäuses 12 zu, wird das mit Fluid belegbare Volumen der Pumpenkammer 72 verringert. Aufgrund des ansteigenden Fluiddrucks in der Pumpenkammer 72 und in einem den Pumpenkolben 36 im Wesentlichen in Richtung der Pumpenlängsachse L durchsetzenden Fluiddurchtrittskanal 74 wird das Einlass-Rückschlagventil 62 noch verstärkt in Richtung seiner Schließstellung belastet, so dass das in der Pumpenkammer 72 enthaltene Fluid nur über ein Auslass-Rückschlagventil 76 aus der Pumpenkammer 72 entweichen und über den Auslassstutzen 20 abströmen kann. Das Auslassrückschlagventil 76 umfasst einen im Pumpenkammergehäuse 70 ausgebildeten Ventilsitz 78 und ein durch eine Ventilfeder 80 gegen diesen Ventilsitz 78 gepresstes, beispielsweise als Kugel ausgebildetes Ventilelement 82. Dabei stützt sich die Ventilfeder 80 an einem den Auslassstutzen 20 des Pumpengehäuses 12 bereitstellenden und in das Pumpenkammergehäuse 78 fluiddicht eingesetzten Stutzenteil 84 ab.

Bewegt sich der Pumpenkolben 36 in der Darstellung der Fig. 1 nach unten, so nimmt das mit Fluid belegbare Volumen der Pumpenkammer 72 zu. Bei dieser Bewegung des Pumpenkolbens 36 kann, unterstützt durch den im Fluideinlasskanal 24 vorherrschenden Fluiddruck, das Ventilelement 64 des Einlassrückschlagventils 62 von seinem Ventilsitz 60 abheben, so dass Fluid aus dem Fluideinlasskanal 24 bzw. aus dem Innenvolumenbereich des Pumpenkolbengehäuses 34 in den Fluiddurchtrittskanal 74 des Pumpenkolbens 36 und somit auch in den Bereich der Pumpenkammer 72 gelangen kann. Ein Rückströmen von bereits aus der Pumpenkammer 72 ausgestoßenem Fluid über den Auslassstutzen 20 ist durch das Auslassrückschlagventil 76 verhindert.

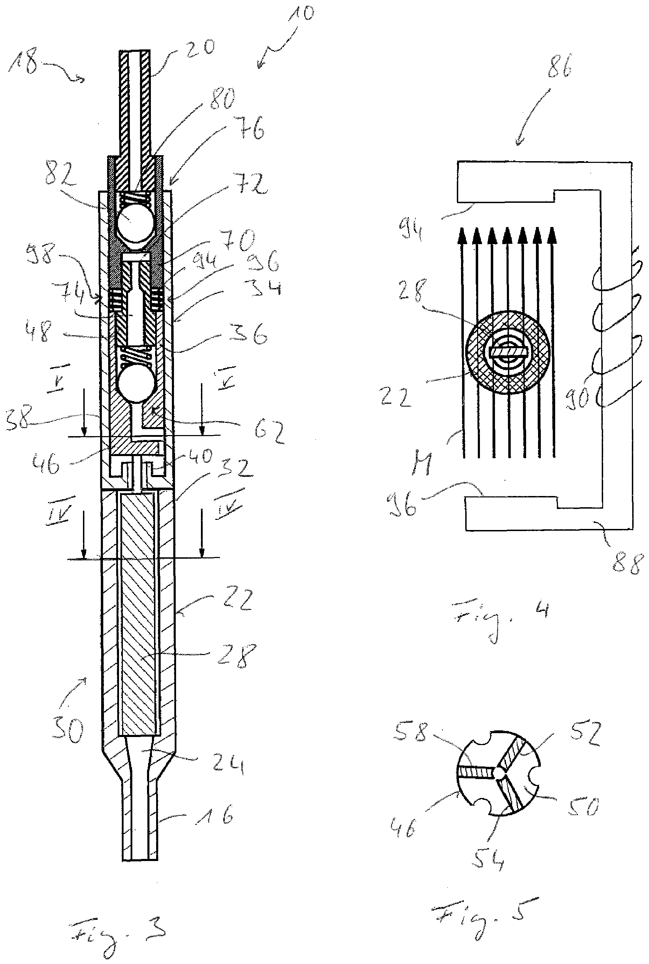

Um diese Hin- und Herbewegung des Pumpenkolbens 36 zum Aufnehmen von Fluid in der Pumpenkammer 72 und zum Ausstoßen von Fluid aus der Pumpenkammer 72 zu bewirken, ist die bereits angesprochene Antriebsanordnung 30 mit ihrem Antriebselement 28 aus magnetischem Formgedächtnismaterial vorgesehen. Die Antriebsanordnung 30 umfasst ferner eine in Fig. 4 in prinzipartiger Weise dargestellte Magnetfelderzeugungsanordnung 86. Diese kann beispielsweise eine um ein Joch 88 aus Metallmaterial geführte Spulenanordnung 90 umfassen. Bei Erregung der Spulenanordnung 90 wird ein Magnetfeld M zwischen den beiden einander gegenüberliegenden Polen 92, 94 des Jochs 88 generiert. Dieses Magnetfeld M erstreckt sich im Wesentlichen orthogonal zur Pumpenlängsachse L und auch orthogonal zu dem plattenartig ausgebildeten Antriebselement 28. Durch die Wechselwirkung mit dem Magnetfeld M ändert das Antriebselement 28 aus magnetischem Formgedächtnismaterial seine Form, so dass dieses, wie dies der Übergang von der den Zustand ohne Magnetfeld darstellenden Fig. 1 zu der den Zustand mit Magnetfeld darstellenden Figur 3 zeigt, seine Form, insbesondere seine Länge, ändert. Mit Zunahme der Länge nimmt die Breite des Antriebselements 28 ab. Auf diese Art und Weise kann eine Längenänderung des Antriebselements 28 von bis zu etwa 10% erreicht werden.

Diese Längenänderung des Antriebselements 28 bei Erzeugung des Magnetfelds M durch die Magnetfelderzeugungsanordnung 86 wird genutzt, um eine entsprechende Verschiebung des Pumpenkolbens 36 hervorzurufen. Insbesondere wird dabei eine Antriebskraft durch das beispielsweise stift- oder bolzenartige Übertragungsorgan 44 auf das Kolbenteil 46 des Pumpenkolbens 36 übertragen. Dabei verschiebt sich der Pumpenkolben entgegen der Rückstellwirkung einer am Kolbenteil 46 einerseits und am Pumpenkammergehäuse 70 andererseits und dabei das Kolbenteil 48 umgebenden Rückstellfeder 94. Diese beispielsweise als Schraubendruckfeder ausgebildete Rückstellfeder 94 bildet somit ein erstes Rückstellelement 96, durch welches der Pumpenkolben 36 in Richtung aus der Pumpenkammer 72 und somit in Richtung Aufnehmen von zu förderndem Fluid in der Pumpenkammer 72 beaufschlagt wird. Gleichzeitig bildet die Rückstellfeder 94 ein zweites Rückstellelement 98, durch welches über den Pumpenkolben 36 bzw. das Kolbenteil 46 und das Übertragungsglied 44 eine Rückstellkraft auf das Antriebselement 28 ausgeübt wird. Dies ist erforderlich, da das Antriebselement 28 aus magnetischem Formgedächtnismaterial zwar seine Form bzw. Länge ändert, wenn dieses dem Magnetfeld M ausgesetzt wird, bei Beendigung der Erzeugung des Magnetfelds M jedoch nicht selbsttätig in seinen zuvor eingenommenen und beispielsweise in Fig. 1 dargestellten Grundzustand zurückkehren kann. Hierzu ist eine externe Krafteinwirkung erforderlich, die im dargestellten Ausgestaltungsbeispiel durch die Rückstellfeder 94 in seiner Funktion als zweites Rückstellelement 98 generiert wird.

Durch das alternierende bzw. periodische Erregen der Magnetfelderzeugungsanordnung 86 bzw. Spulenanordnung 90 und das entsprechend periodische Erzeugen des Magnetfelds M, also das Alternieren zwischen einem Zustand mit Magnetfeld und einem Zustand ohne Magnetfeld bzw. einem Zustand mit stärkerem Magnetfeld und einem Zustand mit schwächerem Magnetfeld, kann eine entsprechende alternierende Hin- und Herbewegung des Pumpenkolbens, einerseits unter Beaufschlagung durch das vermittels der Magnetfelderzeugungsanordnung 86 generierte Magnetfeld M und andererseits durch die Beaufschlagung vermittels der Rückstellfeder 94 hervorgerufen werden. Durch das Einstellen der Periode der Hin- und Herbewegung können die pro Zeiteinheit, also beispielsweise pro Sekunde ausgeführten Arbeitstakte und somit auch das ausgestoßene Volumen des zu fördernden Fluids eingestellt werden. Dabei kann das Volumen der Pumpenkammer 72 in maximalem Ausmaß genutzt werden, wenn bei dieser Hin- und Herbewegung der Pumpenkolben 36 zwischen seinen beiden maximal einnehmbaren Endstellungen hin- und herbewegt wird. Dies ist einerseits eine Endstellung, in welcher das Kolbenteil 46 am Anlageansatz 40 aufliegt, und ist andererseits eine Endstellung, in welcher die Rückstellfeder 94 in maximalem Ausmaß komprimiert ist oder ggf. das Kolbenteil 48 an einem Bodenbereich der Pumpenkammer 72 anstößt.

Bei Einsatz der erfindungsgemäß vorgesehenen Antriebsanordnung 30 kann jedoch auch in einfacher Art und Weise durch entsprechende Einstellung der Feldstärke des Magnetfelds M das Ausmaß der Form- bzw. Längenänderung des Antriebselements 28 eingestellt werden, so dass nicht notwendigerweise der Pumpenkolben 36 zwischen diesen beiden maximalen Endstellungen hin- und herbewegt wird, sondern bei jedem Hub nur eine kürzere Bewegung ausführt und entsprechend auch nur ein kleineres Volumen von Fluid aus der Pumpenkammer 72 ausgestoßen wird. Somit wird nicht bzw. nicht nur durch das Einstellen der Frequenz der Hin- und Herbewegung ein Einfluss auf die Menge des zu fördernden Fluids genommen, sondern es kann insbesondere auch durch das Ausmaß des Hubs, also die Amplitude der Hin- und Herbewegung das geförderte Volumen beeinflusst werden. Dies ermöglicht es, auch sehr kleine Volumina des zu fördernden Fluids mit hoher Präzision als nahezu kontinuierlichen Strom auszustoßen. Beispielsweise kann mit vergleichsweise hoher Frequenz gearbeitet werden. Der Einsatz eines Antriebselements 28 aus magnetischem Formgedächtnismaterial gestattet eine Arbeitsfrequenz im kHz-Bereich. Wenn dabei die Amplitude entsprechend gering eingestellt wird, kann auch ein sehr kleines Volumen des zu fördernden Fluids bei jedem Arbeitstakt ausgestoßen werden. Insbesondere ermöglicht die definierte Erzeugung des Magnetfelds M auch ein allmähliches Verzögern des Pumpenkolbens 36 bei Annäherung an eine jeweilige Endstellung, so dass ein zu wahrnehmbaren Vibrationen bzw. Geräuschen führendes Anschlagen des Pumpenkolbens 36 vermieden werden kann.

## Patentansprüche

1. Dosierpumpe, insbesondere Brennstoffdosierpumpe für ein Fahrzeugheizgerät, umfassend einen in einer Pumpenkammer (72) zum Ausstoßen und Aufnehmen von Fluid hin- und herbewegbaren Pumpenkolben (36) und eine Antriebsanordnung (30) für den Pumpenkolben (36), wobei die Antriebsanordnung (30) wenigstens ein mit magnetischem Formgedächtnismaterial aufgebautes Antriebselement (28) umfasst, wobei das wenigstens eine Antriebselement (28) bei erzeugtem Magnetfeld (M) den Pumpenkolben (36) in einer ersten Beaufschlagungsrichtung beaufschlagt,
**dadurch gekennzeichnet,**
- **dass** die Antriebsanordnung (30) ein dem wenigsten einen Antriebselement (28) zum Zurückstellen des wenigstens einen Antriebselements (28) in einen bei nicht erzeugtem Magnetfeld (M) einzunehmenden Grundzustand zugeordnetes und den Pumpenkolben (36) in einer der ersten Beaufschlagungsrichtung im Wesentlichen entgegengesetzten zweiten Beaufschlagungsrichtung beaufschlagendes Rückstellelement (96, 98) umfasst,
- **dass** das wenigstens eine Antriebselement (28) in einem einen Fluideinlasskanal (24) bereitstellenden Antriebselementengehäuse (22) angeordnet ist,
- **dass** der Pumpenkolben (36) in einem Pumpenkolbengehäuse (34) in Richtung einer Pumpenlängsachse (L) hin- und herbewegbar ist, und
- **dass** das Antriebselementengehäuse (22) und das Pumpenkolbengehäuse (38) eine Durchgangsöffnung (42) für ein das wenigstens eine Antriebselement (28) mit dem Pumpenkolben (36) zur Antriebskraftübertragung koppelndes Übertragungsorgan (44) und für den Durchtritt von Fluid bereitstellen.

2. Dosierpumpe nach Anspruch 1, **dadurch gekennzeichnet, dass** das magnetische Formgedächtnismaterial eine magnetische Formgedächtnislegierung, vorzugsweise NiMnGa-Legierung, umfasst.

3. Dosierpumpe nach Anspruch 1 oder 2, **dadurch gekennzeichnet, dass** die Antriebsanordnung (30) eine Magnetfelderzeugungseinheit (86), vorzugsweise mit einer elektrisch erregbaren Spulenanordnung (90), zur Erzeugung eines auf das wenigstens eine Antriebselement (28) einwirkenden Magnetfeldes (M) umfasst.

4. Dosierpumpe nach Anspruch 3, **dadurch gekennzeichnet, dass** bei Beaufschlagung in der ersten Beaufschlagungsrichtung das wenigstens eine Antriebselement (28) den Pumpenkolben (36) in Richtung Ausstoßen von Fluid aus der Pumpenkammer (72) beaufschlagt.

5. Dosierpumpe nach Anspruch 4, **dadurch gekennzeichnet, dass** bei Beaufschlagung in der zweiten Beaufschlagungsrichtung das Rückstellelement (96, 98) den Pumpenkolben (36) in Richtung Aufnehmen von Fluid in der Pumpenkammer (72) beaufschlagt.

6. Dosierpumpe nach einem der vorangehenden Ansprüche, **dadurch gekennzeichnet, dass** das Rückstellelement (96, 98) eine Rückstellfeder (94) umfasst.

7. Dosierpumpe nach einem der Ansprüche 1-6, **dadurch gekennzeichnet, dass** an dem Pumpenkolbengehäuse (34) ein die Pumpenkammer (72) bereitstellendes Pumpenkammergehäuse (70) vorgesehen ist.

8. Dosierpumpe nach Anspruch 7, **dadurch gekennzeichnet, dass** an dem Pumpenkammergehäuse (70) das den Pumpenkolben (36) beaufschlagende Rückstellelement (96, 98) abgestützt ist.

9. Dosierpumpe nach einem der Ansprüche 1-8, **dadurch gekennzeichnet, dass** in dem Pumpenkolben (36) ein diesen durchsetzender Fluiddurchtrittskanal (74) vorgesehen ist.

10. Dosierpumpe nach einem der Ansprüche 1-9, **dadurch gekennzeichnet, dass** in dem Pumpenkolben (36) ein Einlass-Rückschlagventil (62) vorgesehen ist, oder/und dass in einem Pumpenkammergehäuse (70) ein Auslass-Rückschlagventil (76) vorgesehen ist.

## Claims

1. Feed pump, especially fuel feed pump for a vehicle heater, comprising a pump piston (36) movable to and from in a pump chamber (72) for ejecting and receiving fluid and a driving arrangement (30) for the pump piston (36), wherein the driving arrangement (30) comprises at least one driving element (28) made of magnetic shape memory material; wherein the at least one driving element (28) acts on the pump piston (36) in a first action direction when a magnetic field (M) is generated,
**characterized in that**
- the driving arrangement (30) comprises a resetting element (96, 98), associated with the at least one driving element (28) for resetting the at least one driving element (28) into an initial state to be assumed when no magnetic field (M) is generated, and acting on the pump piston (36) in a second action direction directed essentially opposite the first action direction,
- the at least one driving element (28) is arranged in a driving element housing (22) providing a fluid inlet duct (24),
- the pump piston (36) is movable to and fro in a pump piston housing (34) in the direction of a longitudinal axis (L) of the pump,
- the driving element housing (22) and the pump piston housing (38) provide a passage opening (42) for a transmission element (44) coupling the at least one driving element (28) with the pump piston (36) for transmitting driving force and for the passage of fluid.

2. Feed pump in accordance with claim 1, **characterized in that** the magnetic shape memory material comprises a magnetic shape memory alloy, preferably a NiMnGa alloy.

3. Feed pump in accordance with claim 1 or 2, **characterized in that** the driving arrangement (30) comprises a magnetic field generation unit (86), preferably with an electrically excitable coil arrangement (90), for generating a magnetic field (M) acting on the at least one driving element (28).

4. Feed pump in accordance with claim 3, **characterized in that** the at least one driving element (28) acts on the pump piston (36) in the direction in which fluid is ejected from the pump chamber (72) in case of action in the first action direction.

5. Feed pump in accordance with claim 4, **characterized in that** the resetting element (96, 98) acts on the pump piston (36) in the direction in which fluid is received in the pump chamber (72) in case of action in the second action direction.

6. Feed pump in accordance with one of the preceding claims, **characterized in that** the resetting element (96, 98) comprises a resetting spring (94).

7. Feed pump in accordance with one of claims 1-6, **characterized in that** a pump chamber housing (70) providing the pump chamber (72) is provided at the pump piston housing (34).

8. Feed pump in accordance with claim 7, **characterized in that** the resetting element (96, 98) acting on the pump piston (36) is supported at the pump chamber housing (70).

9. Feed pump in accordance with one of the claims 1-8, **characterized in that** a fluid passage duct (74) passing through the pump piston (36) is provided in the pump piston (36).

10. Feed pump in accordance with one of the claims 1-9, **characterized in that** a nonreturn inlet valve (62) is provided in the pump piston (36) or/and that a nonreturn outlet valve (76) is provided in a pump chamber housing (70).

## Revendications

1. Pompe de dosage, en particulier pompe de dosage de combustible pour un dispositif de chauffage d'un véhicule, comprenant un piston de pompe (36) qui peut être déplacé par un mouvement de va-et-vient dans une chambre de pompe (72) pour recevoir et pour éjecter du fluide, et un arrangement d'entraînement (30) pour le piston de pompe (36), l'arrangement d'entraînement (30) comprenant au moins un élément d'entraînement (28) formé avec du matériau magnétique à mémoire de forme, ledit au moins un élément d'entraînement (28) agissant sur le piston de pompe (36) dans un premier sens d'action quand un champ magnétique (M) est généré,
**caractérisé en ce que**
- l'arrangement d'entraînement (30) comprend un élément de rappel (96, 98), associé audit au moins un élément d'entraînement (28) pour remettre ledit au moins un élément d'entraînement (28) à un état de base à prendre quand aucun champ magnétique (M) est généré, et agissant sur le piston de pompe (36) dans un deuxième sens d'action essentiellement opposé au premier sens d'action,
- ledit au moins un élément d'entraînement (28) est arrange dans un boîtier d'élément d'entraînement (22) prévoyant un canal d'entrée de fluide (24),
- le piston de pompe (36) peut être déplacé par un mouvement de va-et-vient dans un boîtier de piston de pompe (34) dans le sens d'un axe longitudinal de pompe (L),
- le boîtier d'élément d'entraînement (22) et le boîtier de piston de pompe (38) prévoient un orifice de passage (42) pour un membre de transmission (44) accouplant ledit au moins un élément d'entraînement (28) au piston de pompe (36) pour transmettre une force d'entraînement ou/et pour le passage de fluide.

2. Pompe de dosage selon la revendication 1, **caractérisée en ce que** le matériau magnétique à mémoire de forme comprend un alliage magnétique à mémoire de forme, de préférence un alliage NiMnGa.

3. Pompe de dosage selon les revendications 1 ou 2, **caractérisée en ce que** l'arrangement d'entraînement (30) comprend une unité de génération de champ magnétique (86), de préférence avec un arrangement de bobine électriquement excitable (90) pour générer un champ magnétique (M) agissant sur ledit au moins un élément d'entraînement (28).

4. Pompe de dosage selon la revendication 3, **caractérisée en ce que** ledit au moins un élément d'entraînement (28) agit sur le piston de pompe (36) dans le sens éjection de fluide de la chambre de pompe (72) lors d'une action dans le premier sens d'action.

5. Pompe de dosage selon la revendication 4, **caractérisée en ce que** l'élément de rappel (96, 98) agit sur le piston de pompe (36) dans le sens réception de fluide dans la chambre de pompe (72) lors d'une action dans le deuxième sens d'action.

6. Pompe de dosage selon une des revendications précédentes, **caractérisée en ce que** l'élément de rappel (96, 98) comprend un ressort de rappel (94).

7. Pompe de dosage selon une des revendications 1 à 6, **caractérisée en ce qu'**un boitier de chambre de pompe (70) prévoyant la chambre de pompe (72) est prévu au boîtier de piston de pompe (34).

8. Pompe de dosage selon la revendication 7, **caractérisée en ce que** l'élément de rappel (96, 98) agissant sur le piston de pompe (36) est supporté au boitier de chambre de pompe (70).

9. Pompe de dosage selon une des revendications 1 à 8, **caractérisée en ce qu'**un canal de passage de fluide (74) passant par le piston de pompe (36) est prévu à celui-ci.

10. Pompe de dosage selon une des revendications 1 à 9, **caractérisée en ce qu'**un clapet de non-retour d'admission (62) est prévu dans le piston de pompe (36) ou/et **en ce qu'**un clapet de non-retour de sortie (76) est prévu dans un boitier de chambre de pompe (70).
